(19) Europäisches Patentamt
European Patent Office
Office européen des brevets

(11) **EP 4 016 098 B1**

(12) **EUROPÄISCHE PATENTSCHRIFT**

(45) Veröffentlichungstag und Bekanntmachung des Hinweises auf die Patenterteilung:
**16.04.2025 Patentblatt 2025/16**

(21) Anmeldenummer: **20215754.1**

(22) Anmeldetag: **18.12.2020**

(51) Internationale Patentklassifikation (IPC):
**G01R 31/396** (2019.01)

(52) Gemeinsame Patentklassifikation (CPC):
**G01R 31/367; G01R 31/396; H01M 10/425; H01M 10/48; H01M 10/482; H01M 10/486; H01M 50/569;** G01R 31/3647; G01R 31/382; G01R 31/392; H01M 2010/4278

(54) **VERFAHREN UND VORRICHTUNG ZUR ROBUSTEN ONLINE-ZUSTANDSBESTIMMUNG VON GROSSEN BATTERIESPEICHERSYSTEMEN**

METHOD AND DEVICE FOR ROBUST ONLINE DETERMINATION OF THE STATE OF LARGE BATTERY STORAGE SYSTEMS

PROCÉDÉ ET DISPOSITIF DE DÉTERMINATION SOLIDE EN LIGNE DE L'ÉTAT DES GRANDS SYSTÈMES D'ACCUMULATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**22.06.2022 Patentblatt 2022/25**

(73) Patentinhaber: **HOPPECKE Systemtechnik GmbH 08056 Zwickau (DE)**

(72) Erfinder:
• **Petersohn, Ronny
08060 Zwickau (DE)**
• **Schelter, Matthias
09366 Stollberg (DE)**
• **Herrmann, Matthias
08064 Zwickau (DE)**

(74) Vertreter: **Brinkmann & Partner Patentanwälte Partnerschaft mbB Am Seestern 8 40547 Düsseldorf (DE)**

(56) Entgegenhaltungen:
EP-A1- 3 564 693         EP-A1- 3 663 780
DE-A1- 102012 207 817    DE-A1- 102017 106 908
US-A1- 2017 225 584      US-A1- 2020 126 516

**Beschreibung**

Die Erfindung betrifft ein Verfahren zur robusten Online-Zustandsbestimmung durch Bestimmung mehrerer Zustandsgrößen von großen Batteriespeichersystemen gemäß Anspruch 1, sowie eine Vorrichtung zur Durchführung eines derartigen Verfahrens gemäß Anspruch 5.

Lithium-Ionen-Batterien (Li-Ionen-Batterien) sind hocheffiziente Speicher elektrochemischer Energie, die wegen ihrer positiven Eigenschaften sowohl in Bereichen der Consumerelektronik als auch der Mobilität, der Logistik und im Bereich von Stationärspeichern eine zentrale Rolle spielen. Die Nutzung einer Li-Ionen-Batterie erfolgt in der Regel in einem sogenannten Betriebsfenster. Dieses Betriebsfenster von Strom, Spannung und Temperatur ist insofern eingeschränkt, dass ein Verlassen des sicheren Betriebsfensters mit Sicherheitsgefahren wie Brand, Explosion und/oder der Freisetzung giftiger Gase verbunden sein kann. Anders als bei Blei-Säure- oder Nickel-basierten Batteriezellen ist eine Unterbindung wie auch Rekombination der entstandenen Reaktionsprodukte nach derzeitigem Stand der Technik nicht möglich. Eine stabile, zuverlässige und zeitlich hochaufgelöste Zustandserfassung jeder einzelnen Zelle im Li-Ionen-Batteriesystem ist deshalb zwingend erforderlich. Auch wird eine Alterungsgeschwindigkeit durch die Einhaltung des eingeschränkten Betriebsfensters bestimmt.

Für die Speicherung großer Energiemengen in Li-Ionen-Batterien werden viele Einzelzellen in mehreren Parallel- und/oder Serienschaltungen zu großen, teilweise verteilten Batteriesystemen verbunden. Damit verknüpft ist eine breite Verteilung der Zustände der im Verbund enthaltenen einzelnen Zellen. Die Herausforderung besteht hier darin, für jede einzelne Zelle die Batteriezustände sicher zu erfassen, um die Gesamtsicherheit gewährleisten zu können. Die wichtigsten Zustandsgrößen sind der Ladezustand und der Alterungszustand.

Besondere Herausforderungen ergeben sich für Batterien, die im automobilen und industriellen Traktionsbereich sowie in stationären Anwendungen eingesetzt werden. Kennzeichnend dafür sind Lastprofile mit undefinierten Ladungen, wie beispielsweise die Rückgewinnung von Bremsenergie (Rekuperation), Gelegenheitsladungen (Opportunity Charging), Hybridspeicherbetrieb oder der Betrieb in mittleren Ladezuständen im Stationärbereich. Bei derartigen Lastprofilen sind folglich sowohl die Lade- als auch Entladebedingungen nicht konkret definierbar und i.d.R. auch nicht vorhersagbar. Definierte Ladungen an Ladegeräten können in größeren Zyklen oder nie erfolgen. Algorithmen zur Zustandserfassung müssen demnach variabel genug sein, um in einem breiten Feld an Lastprofilen robust zu funktionieren.

Zur Bestimmung von Ladezuständen haben sich unterschiedliche Schätzverfahren etabliert. Diese lassen sich in die Kategorien direkte Messmethoden, modellbasierte Messmethoden und datenbasierten Messmethoden unterteilen, wobei die jeweiligen Kategorien jeweils eine Vielzahl von Messmethoden aufweisen. Jede dieser Messmethoden weist wiederum eine Vielzahl von Vor- und Nachteilen auf.

Für große verteilte Batteriesysteme sind die datenbasierten Methoden mit einem immensen Rechenaufwand verbunden, der nur in ausgelagerten serverbasierten Recheneinheiten realisiert werden kann. In der Praxis kommen daher vorrangig direkte Messmethoden oder modellbasierte Methoden auf dem Batteriemanagementsystem zum Einsatz. Jede einzelne Methode birgt zeitlich nicht konstante Fehler, so dass die Ladezustandserfassung mit einer variablen Ungenauigkeit behaftet ist.

Die Druckschrift EP 3 056 917 B1 offenbart ein Verfahren und eine Vorrichtung zur Schätzung eines Zustands einer Batterie, die EP 2 107 385 B1 zeigt eine Vorrichtung zur Einschätzung eines Zustands einer Batterie und aus der EP 3 136 118 B1 sind eine Vorrichtung und ein Verfahren bekannt, die eine Spannung einer Batterie bestimmen sollen. Die EP 1 562 048 B1 offenbart eine Batteriekapazitäts-Berechnungsmethode, eine Batteriekapazitäts-Berechnungsvorrichtung, sowie ein Batteriekapazitäts-Berechnungsprogramm, während aus der EP 2 502 086 B1 ein Verfahren und eine Vorrichtung zur fehlerkompensierten Strommessung einer Batterie bekannt sind.

Nachteilig an allen vorgenannten Druckschriften ist, dass lediglich ein Schätzverfahren pro zu bestimmender Zustandsgröße eingesetzt wird. Einzelne Schätzverfahren liefern nur in bestimmten Betriebsfenstern hinreichend genaue Schätzwerte. Es ist zu beobachten, dass bei der Verwendung von nur einem Schätzverfahren häufig keine zuverlässigen und genauen Zustandserfassungen bei undefinierten Last- und/oder Temperaturprofilen möglich sind.

In der Druckschrift US 9 960 625 B2 ist zur Verringerung einer daraus resultierenden Ungenauigkeit ein sequenzielles Verfahren vorgeschlagen, wobei mehrere Batterieparameter mittels mehrerer Methoden nacheinander in Folge bestimmt werden. Das Verfahren stellt sich folgendermaßen dar: Ein Parameter A wird durch ein erstes Modell 1 abgeschätzt. Dieser so ermittelte Parameter dient als Eingangsgröße für weitere nachgelagerte Modelle 2...n um weitere Parameter B... Z abzuschätzen.

Nachteilig an dem letztgenannten Verfahren ist, dass ein Fehler während der Benutzung unbekannt bleibt, so dass eine hinreichende Plausibilität und eine hinreichende Zuverlässigkeit nicht gewährleistet werden können. US 2017/225584 A1, EP 3 663 780 A1, DE 10 2012 207817 A1 und EP 3 564 693 A1 offenbaren weitere Beispiele aus dem Stand der Technik für Ansätze zur Bestimmung von Ladezustand und Alterungszustand von Batterien.

Dem gegenüber liegt der Erfindung die Aufgabe zu Grunde, ein Verfahren und eine Vorrichtung zu schaffen, die Zustandsschätzungen von Batteriesystemen mit einer hinreichenden Zuverlässigkeit gewährleisten.

Diese Aufgabe wird gelöst durch ein Verfahren mit den Merkmalen des Patentanspruchs 1 und mit einer Vorrichtung mit den Merkmalen des Patentanspruchs 5. Weitere vorteilhafte Ausgestaltungen der Erfindung sind in den abhängigen Patentansprüchen beschrieben.

Die aus dem Stand der Technik resultierenden Nachteile werden durch eine parallele Anwendung mehrerer Schätzverfahren in einem übergeordneten Batteriemanagementsystem überwunden.

Es werden mehrere Schätzverfahren pro zu bestimmender Zustandsgröße eingesetzt. Diese mehreren Schätzverfahren werden parallel angewendet, wobei sowohl die mehreren Schätzverfahren pro Zustandsgröße parallel ablaufen als auch die weiteren Schätzverfahren für die weiteren Zustandsgrößen parallel ablaufen.

Alle Schätzverfahren werden für jede einzelne Batteriezelle des Batteriesystems parallel eingesetzt.

Es wird nach einer ersten, initialen Zustandsgrößenbestimmung durch eines oder mehrere der Schätzverfahren für eine und/oder mehrere der Zustandsgrößen, der oder die daraus ermittelten Zustandsgrößen, auf Grundlage einer fehlerbasierten Auswahl, den weiteren Schätzverfahren zu Grunde gelegt. Das Verfahren wird zyklisch angewendet, also werden die Schätzverfahren sich wiederholend parallel durchgeführt, wobei jeweils eine in dem vorhergehenden Verfahrensdurchlauf ermittelte Zustandsgröße dem nächsten sich anschließenden Verfahrensdurchlauf zu Grunde gelegt wird.

Besonders bevorzugt ist es, wenn sich die Zustandsgrößen aus zumindest einer, vorzugsweise aus mehreren und/oder der Gesamtheit der folgenden Aufzählung zusammensetzen: Ein Ladezustand des Batteriesystems, der sich, sowie die im Folgenden genannten Zustände auch, auch für Untergruppen auf einer Ebene der Batteriezellen oder einem aus mehreren Batteriezellen zusammengesetzten Zellenverbund, bestimmen lassen kann. Der Ladezustand wird auch als "State of Charge" (SoC) bezeichnet. Ein Alterungszustand, der auch als "State of Health" (SoH) bezeichnet wird, ein Sicherheitszustand, der als "State of Safety" (SoS) bekannt ist, ein Nutzbarkeitszustand, "State of Function" (SoF), eine Ladezustandsverteilung, auch als "State of Balance" (SoB) bezeichnet, sowie eine Zellinnentemperatur, wobei die Zellinnentemperatur auf die Temperatur in einem Inneren einer Batteriezelle bezogen ist.

Für die Zustandsgröße Ladezustand kommen sowohl kontinuierliche als auch diskontinuierliche Schätzverfahren zum Einsatz. Erstere können ohne Vorbedingungen in jedem zeitlich hochaufgelösten Rechenzyklus nahezu in Echtzeit eine neue Zustandsgröße samt Fehler berechnen; Beispiele für die Zustandsgröße Ladezustand sind das Coulomb Counting, sämtliche Formen des Kalman Filters sowie datenbasierte Schätzverfahren. Im Gegensatz dazu sind die diskontinuierlichen Verfahren an Vorbedingungen geknüpft und folglich nicht immer verfügbar; Beispiele für die Zustandsgröße Ladezustand sind Ruhespannungsmessung, Incremental Capacity Analysis (ICA) sowie Lastsprung.

Die ermittelten Fehler entscheiden in jedem Rechenzyklus individuell darüber, welcher der mittels mehrerer Schätzverfahren parallel bestimmten Werte einer Zustandsgröße für die Zustandsbestimmung der jeweiligen Batteriezelle oder des jeweiligen Zellverbunds weiter favorisiert wird.

Die erforderliche Rechenleistung wird für die zur Anwendung kommenden Schätzverfahren, die Anforderungen an die Zyklenfrequenz sowie die geforderte Genauigkeit angepasst.

Eine erfindungsgemäße Vorrichtung zur Durchführung eines vorbeschriebenen Verfahrens weist eine Vielzahl von Temperatursensoren und eine Vielzahl von Spannungssensoren auf. Diese sind jeweils mit Batteriezellen des Batteriesystems in Wirkverbindung, wobei jeweils ein Temperatursensor und ein Spannungssensor an einer Batteriezelle anliegen. Mit anderen Worten weist die Vorrichtung erfindungsgemäß genau so viele Temperatursensoren wie Spannungssensoren und Batteriezellen auf. Somit lassen sich sowohl die Temperatur, als auch die Spannung jeder Batteriezelle des Batteriesystems über die Sensoren erfassen, was eine maximale Dichte an Daten ermöglicht, woraus wiederum eine hohe Genauigkeit zumindest von einem Teil der zu ermittelnden Zustandsgrößen realisierbar ist.

Zusätzlich ist eine Strommessvorrichtung an einem Zellverbund, der aus einer Vielzahl von Batteriezellen gebildet ist, vorgesehen.

Wenn durch eine Vielzahl von Sensoren Daten ermittelt werden, dann sind in vorteilhafter Weise mehrere Recheneinheiten vorgesehen, die zentral oder dezentral angeordnet sind. Diese sind dazu ausgelegt, das erfindungsgemäße Verfahren zu steuern und die von den Sensoren erfassten Daten zu verarbeiten. Vorteilhafterweise sind die Recheneinheiten dazu ausgelegt, die anfallenden Daten nahezu in Echtzeit zu verarbeiten.

Die Recheneinheiten erfassen neben den anfallenden Sensordaten auch die den Daten zu Grunde liegenden Fehler. Ferner sind die Recheneinheiten dazu ausgelegt die anfallenden Daten miteinander und/oder mit in einer Datenbank abgelegten Daten zu vergleichen und eine Bewertung der ermittelten Daten zu übernehmen. Weiterhin weist die Recheneinheit eine Schnittstelle auf, die eine Übermittlung der verarbeiteten und bewerteten Daten ermöglicht.

Den Recheneinheiten ist eine übergeordnete Master-Recheneinheit zugeordnet. Diese ist dazu ausgelegt die von den Recheneinheiten übermittelten Daten zu empfangen, in einer vorbestimmten Art zu bündeln und einem weiter übergeordneten Batteriemanagementsystem zu übermitteln. Durch die Aufteilung in eine Master-Recheneinheit und mehrere Unter-Recheneinheiten, die auch als Slave-Recheneinheiten bezeichnet werden, kann die notwendige Rechenleistung optimiert für die anfallenden Prozesse verwendet werden. Eine besonders schnelle und effiziente Verarbeitung der ermittelten Daten kann so erreicht werden.

Aus Gründen der Messgenauigkeit bietet es sich an, wenn die Spannungssensoren mit einer Messgenauigkeit von 0,5 bis 2 mV, vorzugsweise 1 bis 1,5 mV, insbesondere 1,2 mV ausgebildet sind. Die Auflösung der Spannungssensoren liegt bei 0,05 bis 0,2 mV, besonders bevorzugt bei 0,1 mV.

Aus Gründen der Messgenauigkeit bietet es sich an, wenn die Temperatursensoren mit einer Messgenauigkeit von 0,5 bis 2 K, vorzugsweise 0,8 bis 1,5 K, insbesondere 1,2 K ausgebildet sind. Die Auflösung der Temperatursensoren liegt bei 0,05 bis 0,2 K, besonders bevorzugt bei 0,1 K.

Aus Gründen der Messgenauigkeit bietet es sich an, wenn die Strommessvorrichtung mit einer Messgenauigkeit von <1,5 A, vorzugsweise <1 A, ausgebildet sind. Die Auflösung der Strommessvorrichtung liegt bei 0,5 bis 2 mA, besonders bevorzugt bei 0,8 bis 1,5 mA, insbesondere bei 1 mA.

In einem besonders bevorzugten Ausführungsbeispiel ist die Vorrichtung über redundante, galvanisch entkoppelte Bussysteme von dem Batteriesystem abgekoppelt. Die Spannungsversorgung der Vorrichtung ist von dem Batteriesystem unabhängig und erfolgt vorzugsweise über ein dem Batteriesystem übergeordnetes System, in dem das Batteriesystem integrierbar ist.

Ein Ausführungsbeispiel der Erfindung ist in den Figuren dargestellt.

Es zeigen

Figur 1 ein Flussdiagramm zum prinzipiellen Ablauf eines Verfahrenszyklus am Beispiel der Zustandsgröße Ladezustand (SoC),

Figur 2 ein schematisches Ablaufdiagramm zur Bewertung einer Schätzverfahrens am Beispiel der Zustandsgröße Ladezustand (SoC),

Figur 3 drei zusammenhängende Diagramme zum zeitlichen Ablauf der Bestimmung des Ladezustands (SoC) und

Figur 4 einen Überblick über Zustandsgrößen und der jeweils anwendbaren Schätzverfahren.

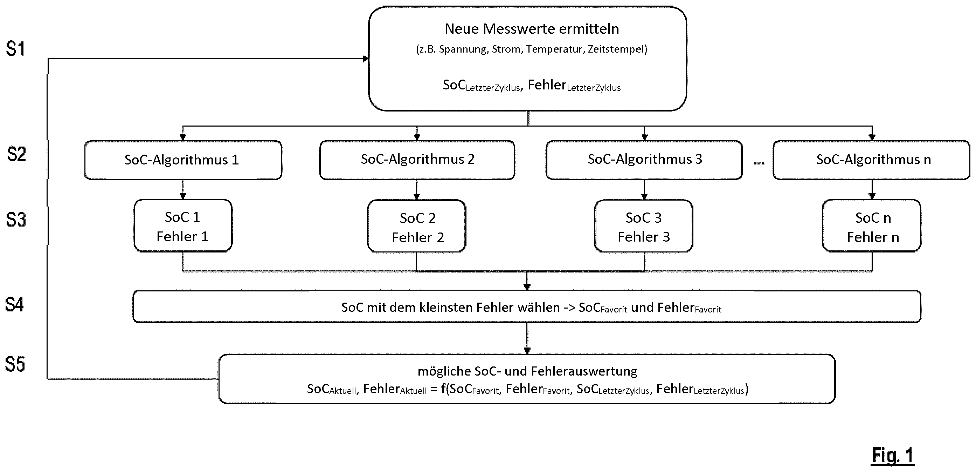

Figur 1 zeigt ein Flussdiagramm zum prinzipiellen Ablauf eines Verfahrenszyklus am Beispiel der Zustandsgröße Ladezustand (SoC). Dieser Verfahrenszyklus ist ebenso auf die Zustandsgößen Alterungszustand (SoH), Sicherheitszustand (SoS), Nutzbarkeitszustand (SoF), Ladezustandsverteilung (SoB) und die Zellinnentemperatur anwendbar. In einem laufenden Messzyklus sind bereits Messdaten verfügbar, die in einem ersten Schritt S1 den nachfolgenden Bestimmungen der Zustandsgrößen zu Grunde gelegt werden. In einem folgenden Schritt S2 werden mehrere Algorithmen 1 bis n zur SoC-Bestimmung angewendet, die jeweils eine Zustandsgröße und einen Fehler, der dieser Zustandsgröße zugeordnet ist, als Ergebnis ausgeben S3. Aus dieser Vielzahl von Zustandsgrößen und Fehlern wird in einem vierten Schritt S4 der SoC mit dem geringsten Fehler ausgewählt. Aus dieser Auswahl wird im folgenden Schritt S5 durch eine Bewertung ein aktueller SoC und ein aktueller Fehler bestimmt, die dem nächsten Zyklus zu Grunde gelegt werden. Die Auswahl erfolgt aus einer Funktion, der der SoC und der Fehler der Schritte S1 und S4 zu Grunde liegen.

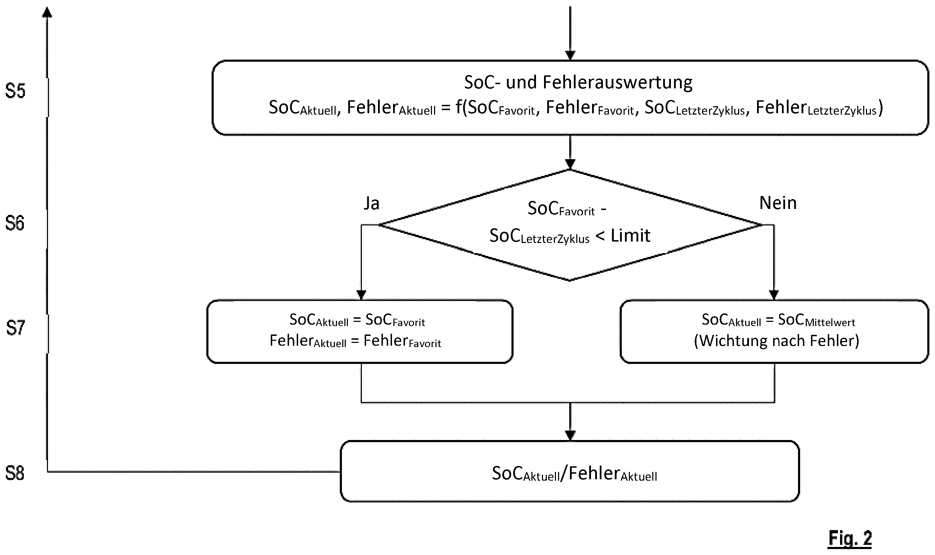

Diese Bewertung ist in dem Ablaufdiagramm in Figur 2 verdeutlicht. Der in S4 ausgewählte SoC und der entsprechende Fehler werden mit dem SoC und dem entsprechenden Fehler des vorhergegangenen Zyklus im Schritt S6 in Relation gesetzt. Wenn sich der ausgewählte SoC und der SoC aus dem vorhergegangenen Zyklus unterscheiden, wird diese Unterscheidung als ein Sprung gewertet. Sprünge im SoC werden im Hinblick auf ihre Größe bewertet. Im Falle eines unplausibel großen Sprunges werden die Zustandsgrößen, hier also der SoC, gemäß der nachstehenden Formel 1 vor und nach dem Sprung anhand ihrer jeweils mitbestimmten Fehler gewichtet.

$$SoC_{mean} = SoC_{favorite} \cdot \frac{Error_{LastCycle}}{Error_{favorite} + Error_{LastCycle}} + SoC_{LastCycle} \cdot \frac{Error_{favorite}}{Error_{favorite} + Error_{LastCycle}}$$

$$Error_{mean} = Error_{favorite} + \frac{Error_{favorite}}{Error_{favorite} + Error_{LastCycle}} \cdot (Error_{LastCycle} - Error_{favorite})$$

*Formel 1*

Folglich sind zwei Optionen in einem folgenden Schritt S7 denkbar. Entweder wird die obenstehende Formel angewendet, oder die Unterschiede zwischen dem beiden SoC und den entsprechenden Fehlern liegen unterhalb einer entsprechenden Toleranzschwelle. Das Ergebnis aus S7 ist dann ein neuer SoC und ein entsprechender Fehler der als abschließender Schritt 8 dargestellt ist. Diese Werte werden dem nächsten Zyklus zu Grunde gelegt. Das Verfahren wird anhand eines konkreten Ausführungsbeispiels im Folgenden eingehender beschrieben.

Als Ausführungsbeispiel zur Zustandsgröße Ladezustand (SoC) wird im Folgenden ein Verfahren und eine Vorrichtung beschrieben, die zur Zustandsbestimmung in einem Batteriesystem aus 6 Zellverbünden bestehend aus jeweils 216 Batteriezellen angewendet wird, diese sind pro Zellverbund in jeweils 6 Module zusammengefasst. Die beispielhaft zum Einsatz kommenden Schätzverfahren sind Incremental Capacity Analysis (ICA), Ruhespannungsabgleich, Lastsprung und Coulomb Counting.

Die Vorrichtung ist so aufgebaut, dass in jedem Verfahrenszyklus aktuelle Messwerte zu Stromflüssen im Batteriesystem aufgenommen werden und zu Beginn eines Zyklus über eine interne Kommunikation der Master-Recheneinheit vorliegen. Ein Zyklenintervall dauert üblicherweise 10 bis 100 ms.

Das Coulomb Counting Verfahren stellt ein kontinuierliches Schätzverfahren dar, während die anderen drei als diskontinuierliche Schätzverfahren bezeichnet werden.

Bei dem Schätzverfahren mittels ICA wird ausgenutzt, dass innerhalb eines Spannungs-Betriebsfensters in unterschiedlichen Bereichen ganz unterschiedliche Ladungsmengen in Batteriezellen geladen bzw. aus Batteriezellen entnommen werden können. Zurückzuführen ist dies auf unterschiedliche Elektrodenreaktionen, die unterschiedliche Standardelektrodenpotenziale aufweisen. Die mathematische Ableitung der geladenen/entnommenen Ladungsmengen nach der Batteriezellspannung zeigt Peaks für die Spannungsbereiche, in denen besonders viel Ladung ladbar/entnehmbar ist. Je nach Zellchemie sind mehrere dieser Peaks feststellbar, deren Lage und Amplitude teilweise alterungsabhängig, teilweise unabhängig von einem Alterungszustand bei bestimmten Ladungszuständen auftreten. Wird während der Lade- und/oder Entladevorgängen ein solches Peakmaximum erkannt, kann daraus direkt der Ladezustand und/oder der Alterungszustand abgelesen werden. Die Vorbedingungen für die ICA sind demnach zum einen ein entsprechender Stromfluss und zum anderen, dass der Ladezustand dabei genau den Bereich überstreicht, in dem entsprechend der Zellchemie ein Peak auftritt.

Beim Ladezustands-Schätzverfahren mittels Ruhespannungsabgleich wird dann die jeweilige Batteriezellenspannung gemessen, wenn ein bestimmter Stromfluss für eine bestimmte Zeit unterschritten ist. Es wird angenommen, dass die Batteriezellenspannung einer Ruhespannung entspricht, was eine fehlerbehaftete Annahme ist. Der Faktor Zeit entscheidet hier maßgeblich über die Größe des Fehlers. Durch ein asymptotische Relaxationsverhalten der Batteriezelle auf ihre Ruhespannung wird der Fehler mit fortschreitender Zeit immer kleiner. Die Ruhespannungskennlinie (SoC über Ruhespannung) ist beispielsweise mittels einer Zuordnungstabelle im Batteriemanagementsystem hinterlegt. Diese ist aufgrund der Temperaturabhängigkeit für mehrere Temperaturen hinterlegt und es wird außerdem berücksichtigt, dass sich diese Kennlinie im Laufe der Batteriezellenalterung verändert. Es wird beispielsweise eine über die übliche Lebensdauer gemittelte Ruhespannungskennlinie pro Temperatur hinterlegt. Auf diese Weise wird der alterungsbedingte Fehler minimiert, ohne einen kritischen Kreisbezug zwischen Ladezustandsbestimmung zur Alterungszustandsbestimmung zur Ladezustandsbestimmung zu erhalten.

Beim Ladezustands-Schätzverfahren mittels Coulomb Counting wird die geladene/entnommene Ladungsmenge fortlaufend in jedem Verfahrenszyklus mitgezählt, um den aktuellen Kapazitätszustand jeder Batteriezelle zu bestimmen. Für dieses Schätzverfahren müssen weiterhin die gemäß des Alterungszustandes aktuell verfügbare Gesamtkapazitäten aller Batteriezellen bekannt sein. Der Quotient aus aktuellem Kapazitätszustand und der aktuell verfügbare Gesamtkapazitäten entspricht dem Ladezustand der Batteriezelle.

Beim Ladezustands-Schätzverfahren mittels Lastsprung wird nach Detektion einer schnellen Änderung der abgegebenen/aufgenommenen Batterieleistung (üblicherweise etwa 50% der Gesamtleistung pro Sekunde) aus den Strömen und Batteriezellenspannungen vor und nach dem Lastsprung die Impedanz jeder Batteriezelle bestimmt. Aus Spannung, Strom und Impedanz wird eine Ruhespannung berechnet.

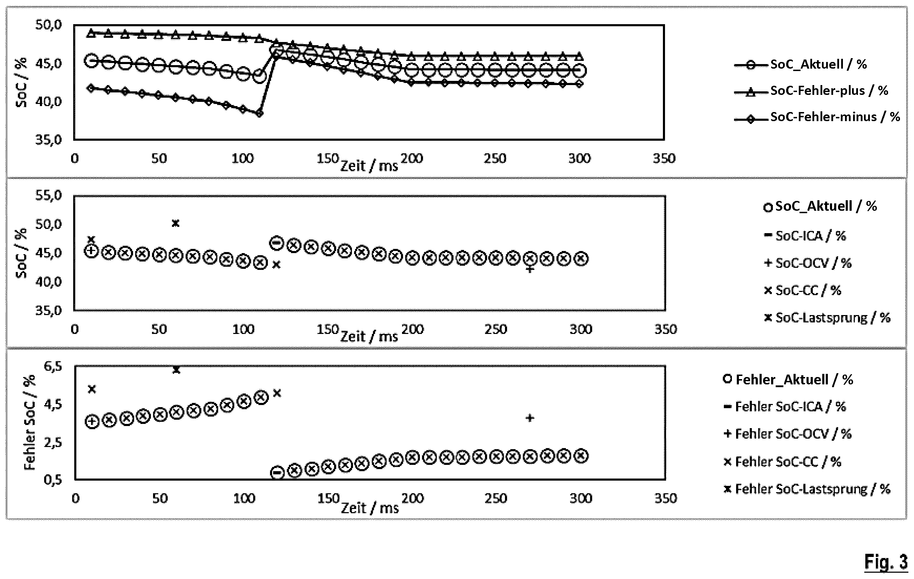

Ein beispielhafter Verlauf des Ladezustandes und dessen Fehler sowie der aus den oben beschriebenen Schätzverfahren ermittelten Ladezustände und deren Fehler sind in Figur 3 dargestellt. Dabei wird Coulomb Counting (CC) kontinuierlich durchgeführt und der Schätzwert des SoC dadurch angepasst. Zu zwei Zeitpunkten ist der Fehler anderer Schätzverfahren kleiner als derjenige des CC Schätzverfahrens ("Fehler SoC-CC"): zu Beginn (erster Messpunkt) und nach 120 ms. Zu diesen Zeitpunkten wird der SoC gemäß des jeweils genaueren Schätzverfahrens aktualisiert, wobei entweder das sogenannte OCV-Verfahren oder das vorab diskutierte ICA-Verfahren zum Einsatz kommt. Zu zwei weiteren Zeitpunkten wurden zwar zum CC alternative Schätzungen durchgeführt (Lastsprung nach 60 ms und OCV nach 270 ms), jedoch war der jeweils berechnete Fehler des Schätzwertes größer als der parallel bestimmte Fehler mittels CC.

Im Folgenden werden weitere Schätzverfahren eingehender beschrieben und anhand eines Ausführungsbeispiels zur Zustandsgröße Alterungszustand (SoH) beschrieben. Bei dem zuvor beispielhaft beschriebenen Ausführungsbeispiel kommt ein Batteriesystem, bestehend aus 6*216 Batteriezellen zum Einsatz.

Bei einem Schätzverfahren durch Kapazitätsbestimmung wird an Hand von zwei aufeinanderfolgenden Ladezustandsbestimmungen die aktuelle Gesamtkapazität bestimmt, wobei die beiden Ladezustandsbestimmungen durch eine Zwischenphase, bestehend aus Ladung, Entladung oder einer Kombination von beiden (typisch: Lastprofil mit Rekuperation), getrennt sind und sich um mindestens 50% Ladezustand unterscheiden. Während der Zwischenphase muss Coulomb Counting (CC) durchgeführt werden. Die Relation zwischen dieser bestimmten Gesamtkapazität und der zu Lebensdauerbeginn bestimmten Gesamtkapazität stellt den Alterungszustand (SoH) dar. Der Fehler dieser SoH-Ermittlung ergibt sich durch Gaußsche Fehlerfortpflanzung aus den mitbestimmten SoC-Fehlern und dem Fehler des CC sowie einem zu Lebensdauerbeginn bestimmten Kapazitätsfehlers.

Beim Schätzverfahren mittels ICA wird zur Bestimmung des Alterungszustandes (SoH) das oben beschriebene Schätzverfahren ICA angewendet, bei dem ausgenutzt wird, dass die Ableitung der Kapazität über der Batteriezellspannung je nach Batteriezellchemie einen oder mehrere alterungsabhängige Peaks aufweist. Dieses Schätzverfahren wurde bereits oben eingehend beschrieben, so dass auf die entsprechenden Textstellen verwiesen wird.

Bei einem Schätzverfahren durch Impedanzbestimmung wird ausgenutzt, dass die Zellimpedanz von Lithium-Ionen-Batterien eine spezifische alterungsbedingte Zunahme zeigt. Im einfachsten Fall, der bei einer großen Zahl von Batteriezellen unterschiedlicher Chemien auftritt, verläuft diese Zunahme linear zum Alterungszustand (SoH). Durch Online-Bestimmung der Zellimpedanzen mittels zuvor eingehend beschriebenen Lastsprung wird anhand der spezifischen Impedanz-Alterungskurve, die in einer Zuordnungstabelle in der Vorrichtung vorgehalten wird, der Alterungszustand bestimmt.

Das Schätzverfahren der Alterungsbestimmung mittels Bestimmung einer irreversiblen Dickenzunahme umfasst die Messung der Batteriezelldicke und deren Korrelation mit dem Alterungszustand. Für die Dickenbestimmung sind sowohl diejenigen Messverfahren anwendbar, bei denen die Messvorrichtung aufgrund geringen Platzbedarfs innerhalb von Batteriezellmodulen untergebracht sein kann als auch solche, deren Vorrichtung außerhalb der Zellmodule positioniert ist und wobei die Erfassung durch berührungslose Messverfahren erfolgt (optisch, akustisch, magnetisch oder elektromagnetisch). Die spezifische Dickenwachstumskurve über den zulässigen Alterungsbereich wird in einer Zuordnungstabelle vorgehalten. Die Dickenbestimmung erfolgt in einem definierten Ladezustandsbereich, um Fehler durch das ladezustandsabhängige reversible Dickenwachstum zu minimieren. Nach erfolgreicher Dickenbestimmung ausgewählter oder aller Batteriezellen wird mittels der Zuordnungstabelle der Alterungszustand abgeschätzt.

Für Batteriezellen mit flexiblem Zellgehäuse ("Pouch-Zellen") erfolgt bei fester Einspannung in einem Modulgehäuse zwar kein Dickenwachstum, der Zellinnendruck nimmt alterungsbedingt jedoch zu. Für solche Batteriezellen ist der Innendruck von außen messbar. Beispielsweise durch dünne Absolutdrucksensoren zwischen zwei Batteriezellen bzw. zwischen einer Batteriezelle und einer festen, an die Batteriezelle angrenzenden Oberfläche, wird der irreversible Druckanstieg bestimmt. Analog zur vorbeschriebenen Dickenbestimmung erfolgt der Druckanstieg in einem definierten Ladezustandsbereich, um Fehler durch reversible Prozesse zu minimieren. Auch ist die Korrelation zwischen irreversiblem Zellinnendruck und Alterungszustand in einer Zuordnungstabelle hinterlegt.

Bei einem Schätzverfahren mittels Rainflow-Zähl-Algorithmus werden komplexe Lastprofile in Mikro Zyklen zerlegt. Hierfür erfolgt die Umwandlung des Profils in eine Folge nach SoC klassierter Umkehrpunkte und eine anschließende Zählung von geschlossenen Hysteresen. Dadurch ist die Ermittlung des mittleren Ladezustands sowie der Entladetiefe (DoD) möglich. Durch vorangegangene Laboruntersuchungen oder Felddaten kann jedem absolvierten (Mikro) Zyklus eine Schädigung zugeordnet und aufsummiert werden. Die Schädigung beschreibt hierbei den Kapazitätsverlust und/oder den Anstieg der Impedanz. Die Genauigkeit des Rainflow-Zähl-Algorithmus ist maßgeblich von der Ladezustandsschätzung abhängig.

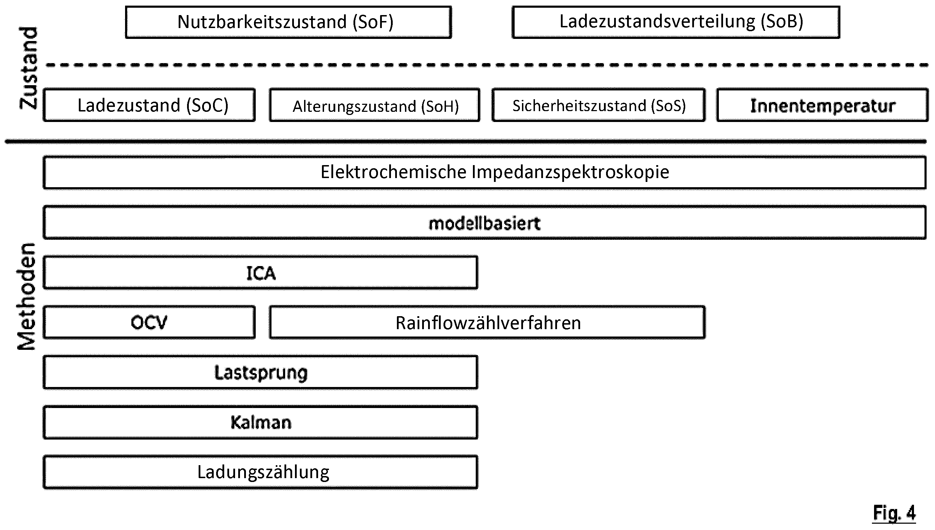

Analog zu den beschriebenen Zustandsgrößen Ladezustand und Alterungszustand wird mittels paralleler Anwendung verschiedener Schätzverfahren der Sicherheitszustand ("SoS"), der Nutzbarkeitszustand ("SoF"), die Ladezustandsverteilung ("SoB") die Zellinnentemperaturen sowie deren jeweilige Fehler abgeschätzt. Einen Überblick über die anwendbaren Schätzverfahren gibt die Darstellung in Figur 4. Der SoF und der SoB sind dabei übergeordnete Zustandsgrößen, die sich aus den Zustandsgrößen SoC und SoH beziehungsweise aus SoC und Innentemperatur ermitteln lassen. Die anwendbaren Methoden sind vorstehend bereits diskutiert, sodass eine Wiederholung an dieser Stelle obsolet erscheint.

Eine erfindungsgemäße Vorrichtung wird im Folgenden anhand des vorstehenden Ausführungsbeispiels beschrieben:

Die erfindungsgemäße Vorrichtung umfasst eine Vielzahl von Temperatur- und Spannungssensoren an jeder der 1296 im Batteriesystem verbauten Batteriezellen, eine Strommessvorrichtung an jedem der sechs Zellverbünde sowie eine oder mehrere Recheneinheiten, die zentral oder verteilt den zeitlichen Ablauf des erfindungsgemäßen Verfahrens steuern, die Erfassung der Sensordaten übernehmen und die Zustandsgrößen und deren Fehler berechnen, vergleichen und anschließend die Änderung bewerten. Zur Bewältigung des vergleichsweise immensen Rechenaufwandes ist die Berechnung der Zustandsgrößen auf Untereinheiten verteilt (Master-Slave-System). Die zeitlich hochaufgelöste Ermittlung und Bewertung der Zustandsgrößen erfolgt für jede Batteriezelle von einer ihr zugeordneten Recheneinheit. Die Kommunikation der ermittelten Zustandsgrößen erfolgt von diesen Recheneinheit zu einer zentralen, übergeordneten Master-Recheneinheit. Diese bündelt die Informationen und kommuniziert sie zum übergeordneten Energiemanagement bzw. zu einem Batteriemanagementsystem (BMS) (z.B. Fahrzeugrechner bei Traktionsbatterien).

Das BMS ermöglicht eine synchrone Erfassung von internen Batterieströmen und Einzelzellspannungen sowie deren Verarbeitung von mindestens zehn Datenpunkten pro Sekunde, die insbesondere für den oben beschriebenen Lastsprungalgorithmus erforderlich ist.

Das BMS überwacht die ordnungsgemäße Funktion der in der Batterie verbauten Sensor- und Aktor-Einheiten sowie der Datenverarbeitung zum einen durch Selbstkontrollfunktionen der Recheneinheiten und ihrer Peripherie, zum anderen durch redundante Ausführung der Verarbeitungseinheiten sowie ferner durch Plausibilitätsabfragen der in den Sensoreinheiten erfassten Daten.

Das BMS ist nicht in der Hochspannungsbatterie verbaut, sondern über redundante, galvanisch entkoppelte Bussysteme an die Untereinheiten angeschlossen. Die Versorgung zumindest der BMS Master-Recheneinheit erfolgt beispielsweise aus einem Bordnetz eines Fahrzeugs, in dem das BMS, sowie das Batteriesystem integriert sind. So wird gewährleistet, dass bei einem Defekt des Batteriesystems und/oder kleiner Untergruppen des Batteriesystems das BMS immer noch funktionstüchtig ist und die Aktorik auslösen kann.

Auf Grund der verhältnismäßig komplexen Algorithmen werden im BMS Mikrocontroller mit einer Flash-Speichergröße von mindestens 2,5 MB und leistungsfähiger Multicore-Prozessor-Architektur eingesetzt, wobei trotz erhöhter Performance der Eigenstromverbrauch des BMS im Standby-Betrieb maximal 100 µA beträgt.

Neben den oben genannten Funktionen wird ein Thermomanagement über das BMS bereitgestellt, welches die Temperaturerfassung und eine Ansteuerung der Aktoren umfasst.

Um eine Manipulation der Algorithmen durch Dritte zu verhindern, werden sogenannte Krypto-Algorithmen angewendet.

Offenbart ist ein Verfahren und eine Vorrichtung zur robusten Online-Zustandsbestimmung von großen Batteriespeichersystemen, wobei mehrere Zustandsgrößen und deren Fehler anhand mehrerer paralleler Schätzverfahren ermittelbar sind.

**Bezugszeichenliste**

S1    Schritt 1
S2    Schritt 2
S3    Schritt 3
S4    Schritt 4
S5    Schritt 5
S6    Schritt 6
S7    Schritt 7
S8    Schritt 8

**Patentansprüche**

1. Verfahren zur zyklischen Zustandsbestimmung eines eine Mehrzahl von Batteriezellen aufweisenden Batteriesystems,

    bei dem in einem Zyklus je Batteriezelle eine Mehrzahl von unterschiedlichen Zustandsgrößen bestimmt wird, indem je zu bestimmender Zustandsgröße eine Mehrzahl von unterschiedlichen Schätzverfahren parallel angewendet wird, wobei die Schätzverfahren die jeweilige Zustandsgröße und einen der Zustandsgröße zugeordneten Fehler ausgeben,
    bei dem je zu bestimmender Zustandsgröße aus der Vielzahl der durch die Schätzverfahren ausgegebenen Zustandsgrößen die Zustandsgröße mit dem geringsten Fehler ausgesucht wird und
    bei dem die ausgewählte Zustandsgröße und der dieser Zustandsgröße zugehörige Fehler als aktuelle Zustandsgröße und aktueller Fehler dem nächsten Verfahrenszyklus zugrunde gelegt werden.

2. Verfahren nach Anspruch 1, **dadurch gekennzeichnet, dass** ein Ladezustand, ein Alterungszustand, ein Sicherheitszustand, ein Nutzbarkeitszustand, eine Ladezustandsverteilung und/oder eine Batteriezelleninnentemperatur eine Auswahl und/oder eine Kombination der zu ermittelnden Zustandsgrößen darstellen.

3. Verfahren nach Anspruch 1 oder 2, **dadurch gekennzeichnet, dass** Incremental Capacity Analysis (ICA) Ruhespannungsabgleich, Lastsprung oder Coulomb Counting als Schätzverfahren zum Einsatz kommen.

4. Verfahren nach Anspruch 1 oder 2, bei dem ein Schätzverfahren durch Kapazitätsbestimmung, durch Impedanzbestimmung, mittels Bestimmung einer irreversiblen Dickenzunahme oder mittels Rainflow-Zähl-Algorithmus durchgeführt wird.

**5.** Vorrichtung, die dazu eingerichtet ist, ein Verfahren nach einem der vorhergehenden Ansprüche 1 bis 4 durchzuführen, mit einer Vielzahl von Temperatur- und Spannungssensoren, die mit den Batteriezellen des Batteriesystems in Wirkverbindung stehen, wobei jeweils ein Temperatursensor und ein Spannungssensor an einer Batteriezelle anliegen, wobei jeweils eine Strommessvorrichtung an einem Zellverbund vorgesehen ist, wobei mehrere Rechneneinheiten vorgesehen sind, die zur Steuerung des Verfahrens ausgelegt sind und die die von den Sensoren erfassten Daten verarbeiten, wobei die Rechnereinheiten ausgelegt sind, neben den erfassten Daten auch deren Fehler zu ermitteln, die Daten und die Fehler miteinander zu vergleichen und eine Bewertung vorzunehmen, wobei mehreren Rechnereinheiten eine übergeordnete Master-Rechnereinheit zugeordnet ist, die ausgelegt ist, die von den Rechnereinheiten erfassten Daten zu empfangen, zu bündeln und einem übergeordneten Batteriemanagementsystem zu übermitteln.

**6.** Vorrichtung nach Anspruch 5, wobei die Spannungssensoren ausgelegt sind mit einer Messgenauigkeit von 0,5 bis 2 mV, vorzugsweise 1 bis 1,5 mV, vorzugsweise 1,2 mV und einer Auflösung von 0,05 bis 0,2 mV, vorzugsweise 0,1 mV betrieben zu werden.

**7.** Vorrichtung nach Anspruch 5, wobei die Temperatursensoren ausgelegt sind mit einer Messgenauigkeit von 0,5 bis 2 K, vorzugsweise 0,8 bis 1,5 K, insbesondere von 1K und einer Auflösung von 1/20 bis 1/5 K, vorzugsweise 1/10 K betrieben zu werden.

**8.** Vorrichtung nach Anspruch 5, wobei die Strommessvorrichtung dazu ausgelegt ist mit einer Messgenauigkeit von <1,5 A, vorzugsweise <1 A und einer Auflösung von 0,5 bis 2 mA, vorzugsweise 0,8 bis 1,5 mA, vorzugsweise 1 mA betrieben zu werden.

**9.** Vorrichtung nach Anspruch 5, wobei die Vorrichtung über redundante, galvanisch entkoppelte Bussysteme von dem Batteriesystem entfernt ausgebildet ist und mit einer von dem Batteriesystem unabhängigen Spannungsversorgung verbunden ist.

**Claims**

**1.** Method for cyclic determination of the state of battery system including a plurality of battery cells,

in which, in one cycle per battery cell, a plurality of different state variables is determined by a plurality of different estimation processes per state variable to be determined is applied in parallel, wherein the estimation processes output the respective state variable and an error assigned to the state variable,
in which, for each state variable to be determined, the state variable with the lowest error is selected from the plurality of state variables output by the estimation methods and
in which the selected state variable and the error associated with this state variable are used as the current state variable and current error in the next process cycle.

**2.** Method according to claim 1, **characterized in that** a state of charge, a state of aging, a state of safety, a state of usability, a state-of-charge distribution and/or a battery cell internal temperature represent a selection and/or a combination of the state variables to be determined.

**3.** Method according to claim 1 or 2, **characterized in that** Incremental Capacity Analysis (ICA) open-circuit voltage adjustment, step change in load or Coulomb Counting are used as estimation methods.

**4.** Method according to claim 1 or 2, in which an estimation procedure is carried out by capacity determination, impedance determination, determination of an irreversible thickness increase or by means of a Rainflow counting algorithm.

**5.** Device adapted for carrying our a method according to any one of the preceding claims 1 to 4, comprising a plurality of temperature and voltage sensors operationally connected to the battery cells, wherein a temperature sensor and a voltage sensor are respectively applied to a battery cell, wherein a current measurement device is respectively provided at a cell bond, wherein several computing units are provided which are designed for controlling the method and which process the data collected by the sensors, wherein the computing units are configured to not only determine the data collected but also its errors, compare the data and the errors with each other and carry out an evaluation, wherein several computing units are assigned a higher-level master computing unit that is designed to receive the data recorded by the computing units, to bundle it and to transmit it to a higher-level battery management system.

6. Device according to claim 5, wherein the voltage sensors are designed to be operated with a measuring accuracy of 0.5 to 2 mV, preferably 1 to 1.5 mV, preferably 1.2 mV, and a resolution of 0.05 to 0.2 mV, preferably 0.1 mV.

7. Device according to claim 5, wherein the temperature sensors are designed to be operated with a measuring accuracy of 0.5 to 2 K, preferably 0.8 to 1.5 K, in particular 1 K, and a resolution of 1/20 to 1/5 K, preferably 1/10 K.

8. Device according to claim 5, wherein the current measurement device is designed to be operated with a measuring accuracy of <1,5 A, preferably < 1 A, and a resolution of 0.5 to 2 mA, preferably 0.8 to 1.5 mA, preferably 1 mA.

9. Device according to claim 5, wherein the device is designed with redundant, galvanically decoupled bus systems remote from the battery system and is connected to a voltage supply that is independent of the battery system.

**Revendications**

1. Procédé de détermination cyclique de l'état d'un système de batterie comprenant plusieurs éléments de batterie,

   dans lequel, dans un cycle par élément de batterie, une pluralité de variables d'état différentes est déterminée par une pluralité de processus d'estimation différents, chaque variable d'état à déterminer étant appliquée en parallèle, les processus d'estimation produisant la variable d'état respective et une erreur affectée à la variable d'état,
   dans lequel, pour chaque variable d'état à déterminer, la variable d'état présentant l'erreur la plus faible est sélectionnée parmi la pluralité de variables d'état produites par les processus d'estimation, et
   dans lequel la variable d'état sélectionnée et l'erreur associée à cette variable d'état sont utilisées comme variable d'état courante et erreur courante dans le cycle de traitement suivant.

2. Procédé selon la revendication 1, **caractérisée en ce qu'**un état de charge, un état de vieillissement, un état de sécurité, un état d'utilisabilité, une distribution de l'état de charge et/ou une température interne de l'élément de batterie représentent une sélection et/ou une combinaison des variables d'état à déterminer.

3. Procédé selon la revendication 1 ou 2, **caractérisée en ce que** l'analyse incrémentale de la capacité (ICA), l'ajustement de la tension en circuit ouvert, la variation progressive de la charge ou le comptage de Coulomb sont utilisés comme méthodes d'estimation.

4. Procédé selon la revendication 1 ou 2, dans lequel une procédure d'estimation est effectuée par la détermination de la capacité, la détermination de l'impédance, la détermination d'une augmentation irréversible de l'épaisseur ou au moyen d'un algorithme de comptage Rainflow.

5. Dispositif adapté à la mise en oeuvre d'un procédé selon l'une quelconque des revendications précédentes 1 à 4, comprenant une pluralité de capteurs de température et de tension connectés de manière opérationnelle aux éléments de batterie, dans lequel un capteur de température et un capteur de tension sont respectivement appliqués à un élément de batterie, dans lequel un dispositif de mesure de courant est respectivement prévu à un réseau de cellules, dans lequel plusieurs unités de calcul sont prévues qui sont conçues pour contrôler le procédé et qui traitent les données collectées par les capteurs, dans lequel les unités de calcul sont configurées pour déterminer non seulement les données collectées mais aussi leurs erreurs, pour comparer les données et les erreurs entre elles et pour effectuer une évaluation, dans lequel plusieurs unités de calcul sont associées à une unité de calcul principale de niveau supérieur conçue pour recevoir les données enregistrées par les unités de calcul, pour les regrouper et pour les transmettre à un système de gestion de la batterie de niveau supérieur.

6. Dispositif selon la revendication 5, dans lequel les capteurs de tension sont conçus pour fonctionner avec une précision de mesure de 0,5 à 2 mV, de préférence de 1 à 1,5 mV, de préférence de 1,2 mV, et une résolution de 0,05 à 0,2 mV, de préférence de 0,1 mV.

7. Dispositif selon la revendication 5, dans lequel les capteurs de température sont conçus pour fonctionner avec une précision de mesure de 0,5 à 2 K, de préférence de 0,8 à 1,5 K, en particulier 1 K, et une résolution de 1/20 à 1/5 K, de préférence 1/10 K.

8. Dispositif selon la revendication 5, dans lequel le dispositif de mesure du courant est conçu pour fonctionner avec une précision de mesure de <1,5 A, de préférence <1 A, et une résolution de 0,5 à 2 mA, de préférence 0,8 à 1,5 mA, de préférence 1 mA.

9. Dispositif selon la revendication 5, dans lequel le dispositif est conçu avec des systèmes de bus redondants, découplés galvaniquement, éloignés du système de batterie et connectés à une alimentation en tension indépendante du système de batterie.

**S1** — Neue Messwerte ermitteln (z.B. Spannung, Strom, Temperatur, Zeitstempel)

$SoC_{LetzterZyklus}$, $Fehler_{LetzterZyklus}$

**S2** — SoC-Algorithmus 1 | SoC-Algorithmus 2 | SoC-Algorithmus 3 | ... | SoC-Algorithmus n

**S3** — SoC 1 / Fehler 1 | SoC 2 / Fehler 2 | SoC 3 / Fehler 3 | SoC n / Fehler n

**S4** — SoC mit dem kleinsten Fehler wählen -> $SoC_{Favorit}$ und $Fehler_{Favorit}$

**S5** — mögliche SoC- und Fehlerauswertung

$SoC_{Aktuell}$, $Fehler_{Aktuell} = f(SoC_{Favorit}, Fehler_{Favorit}, SoC_{LetzterZyklus}, Fehler_{LetzterZyklus})$

__Fig. 1__

11

S5 — SoC- und Fehlerauswertung

$$SoC_{Aktuell}, Fehler_{Aktuell} = f(SoC_{Favorit}, Fehler_{Favorit}, SoC_{LetzterZyklus}, Fehler_{LetzterZyklus})$$

S6 — $SoC_{Favorit} - SoC_{LetzterZyklus} < Limit$

Ja / Nein

S7 — Ja: $SoC_{Aktuell} = SoC_{Favorit}$, $Fehler_{Aktuell} = Fehler_{Favorit}$

Nein: $SoC_{Aktuell} = SoC_{Mittelwert}$ (Wichtung nach Fehler)

S8 — $SoC_{Aktuell}/Fehler_{Aktuell}$

Fig. 2

**Fig. 3**

**Zustand**

| Nutzbarkeitszustand (SoF) | | Ladezustandsverteilung (SoB) |
|---|---|---|

| Ladezustand (SoC) | Alterungszustand (SoH) | Sicherheitszustand (SoS) | **Innentemperatur** |
|---|---|---|---|

**Methoden**

| Elektrochemische Impedanzspektroskopie |
|---|

| **modellbasiert** |
|---|

| **ICA** |
|---|

| **OCV** | Rainflowzählverfahren |
|---|---|

| **Lastsprung** |
|---|

| **Kalman** |
|---|

| Ladungszählung |
|---|

**Fig. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3056917 B1
- EP 2107385 B1
- EP 3136118 B1
- EP 1562048 B1
- EP 2502086 B1
- US 9960625 B2
- US 2017225584 A1
- EP 3663780 A1
- DE 102012207817 A1
- EP 3564693 A1